# EUROPEAN PATENT APPLICATION

(11) **EP 3 713 080 A1**
(43) Date of publication of application: **23.09.2020**
(21) Application number: 19163908.7
(22) Date of filing: 19.03.2019
(51) Int. Cl.: H02S 40/30, H02S 20/26, H02S 40/32, H02S 40/34, H01L 31/02, H01L 31/048

(54) **CONSTRUCTION PANEL FOR RAILINGS AND/OR DELIMITATION COMPRISING SOLAR CELLS**

(71) Applicant: H. Glass SA, 1690 Villaz-St-Pierre (CH)
(72) Inventor: FRIESEN, Thomas, 1742 Autigny (CH)
(74) Representative: Schneiter, Sorin

(57) **Abstract**

The present invention provides a construction panel comprising a photovoltaic module comprising a plurality of dye-sensitized solar cells. The construction panel may be used, for example, for railings. In an embodiment, the panel comprises a power optimizer integrated in the panel. In an embodiment, the construction element comprises two transparent glass or plastic plates with the photovoltaic module being sandwiched between the two transparent plates. The construction panel may be used with any available profiles and/or support structures for railings, in a similar manner as a simple glass panel.

## Description

### Technical Field

The present invention relates to construction panels and to construction elements, railings, and delimitation walls comprising the construction panel. The construction panels comprise photovoltaic modules and are thus adapted to produce electricity from light impinging on the construction panels.

### Prior Art and the Problem Underlying the Invention

Railings and other types of delimitations including balustrades bear a potential as support for photovoltaic panels. Some railings and delimitations comprise glass plates, and one may envisage using a photovoltaic panel instead of a simple glass plate, so as to make use of an exposure that may be suitable to generate electricity.

US 2007/0079861 A1 discloses a panel for a solar rail or railing system comprising two translucent, tempered glass panels and an array of spaced apart solar cells sandwiched between the glass panels.

The use of solar cell panels in railings entails a bunch of technical problems and challenges.

A first problem is associated with the connection of a plurality of solar modules, in case these modules do not have exactly the same orientation and thus the amount of light impinging on the solar cells varies between the panels as the solar cells produce different amounts of current. In classical settings of roof installations, the problem may be addressed by using a microinverter for each panel. In a railing setting, the need for using panels having different orientations is particularly pronounced, for example in order to be able to provide a railing having a corner or a railing extending not along a straight line but along a curve, for example.

Furthermore, in construction, numerous support structures of various designs are available. Typically, the solar cell panel as disclosed in US 2007/0079861 is provided with a tailored handrail and footing, which means that a customer or installer has no longer the option of choosing freely a commercially available or customized handrail and footing design, but is forced to use the particular support structure (handrail and footing), that is provided together with the photovoltaic panel. It is noted that the handrail or footing that is provided with the panel generally contains the cables for connecting the various panels, which explains why prior art photovoltaic railings generally come with their own handrail and footing support structures.

In view of the above, it is an objective of the invention to provide a photovoltaic construction panel suitable for use in railings, which panel can be used in combination with many railing designs as available on the market. In other words, the panel can preferably be combined with commercially available railing designs and may thus be selected by a customer, user, installer and/or building planner independently from the photovoltaic panel.

A further problem of using photovoltaic panels in outdoor applications stems from the dangers associated with electricity in general. In typical rooftop mounted systems, solar cell panels are connected in series so as to achieve a targeted voltage that requires appropriate safety measures in terms of connecting cable thickness, the presence of fuses, and the like. It is an objective of the present invention to provide a photovoltaic panel for use in multi-panel systems and constructions that do not exceed a particular voltage and/or wattage, such that particular norms and measures for higher voltage/wattage devices, such as the IEC certification (Operated by the IEC System of Conformity Assessment Schemes for Electrotechnical Equipment and Components (IECEE)), can be avoided. It is an objective to provide a class III photovoltaic product of norm IEC 61140, as also specified in the norm IEC 61730-1:2016.

It is an objective of the invention to provide a photovoltaic panel that operates bifacially, such that electricity is produced from light that impinges on the panel from either side. This would make it possible to produce electricity independently from the orientation and exposure of the panel and also to make use of light that has been reflected from surrounding structures, for example lying behind (e.g. on the backside of) the panel. In total, more light could be utilized for the production of electricity.

The present invention addresses the problems depicted above.

### Summary of the Invention

Remarkably, the inventors provide a photovoltaic panel comprising dye-sensitized solar cells, which panel is suitable for use in the construction of railings and/or delimitation walls.

In particular, the photovoltaic panel can be used as classical glass panels for use in construction of railings and delimitation walls, for example.

In a first aspect, the present invention provides a (photovoltaic) construction panel for a railing and/or delimitation wall, the panel comprising two plates made of glass or transparent plastics, and, arranged between said two plates, a photovoltaic module comprising a plurality of dye-sensitized and/or perovskite solar cells, wherein a power optimizing element for controlling the current output of said module is integrated in said photovoltaic panel.

In an aspect, the present invention provides a (photovoltaic) construction panel for a railing and/or delimitation wall, the panel comprising two plates made of glass or transparent plastics, and, arranged between said two plates, a photovoltaic module comprising a plurality of dye-sensitized and/or perovskite solar cells.

In an aspect, the present invention provides a construction panel for a railing and/or delimitation wall, the panel comprising a photovoltaic module comprising a plurality of dye-sensitized and/or perovskite solar cells, wherein a power optimizing element for controlling the voltage output of said module is integrated in said photovoltaic panel.

In an aspect, the invention provides a construction panel comprising the photovoltaic module and/or the power optimizing element.

Further aspects and preferred embodiments of the invention are defined herein below and in the appended claims. Further features and advantages of the invention will become apparent to the skilled person from the description of the preferred embodiments given below.

### Brief Description of the Drawings

**Figure 1** schematically represents a perspective view of a photovoltaic panel, in which inside components are shown in dashed lines.
**Figure 2** shows a front elevational view of the photovoltaic panel shown in Fig. 1, in which inside components are also shown in dashed lines.
**Figure 3** shows a longitudinal cross section of the photovoltaic panel shown in Figure 1, the cross section being drawn along the line B-B in Fig. 2.
**Figure 4** shows a perspective exploded view of the photovoltaic construction panel shown in Figs 1-3.
**Figure 5** shows a cross section of the top edge of the panel of an embodiment of the invention, on which a handrail is provided, showing the disposal of cables within the construction panel.
**Figures 6A, 6B** and **6C** show current voltage curves of construction panels of the invention operating under different environmental conditions for illustrating the power optimizing element in accordance with embodiments of the invention.
**Figure 7** illustrates the bifacial light absorbing property of the panel of an embodiment of the invention when provided as a railing of a balcony.
**Figure 8** illustrates a group of construction panels of the invention connected in parallel and connected to a microinverter.

### Detailed Description of the Preferred Embodiments

The present invention provides a photovoltaic panel that is adapted for use as a photovoltaic construction panel, in particular for railings and delimitation walls. Preferably, the photovoltaic panel is useful for balcony railings, stair railings, and generally railings of any places, viewpoints, patios, terraces, and the like. In view of the preferred use of the panels, the expressions "photovoltaic panels", "construction panels" and "photovoltaic construction panels" can be used interchangeably in the present specification. The construction panel may also be referred to as "railing panel".

The construction panel comprises a photovoltaic module. The photovoltaic module preferably comprises a plurality of dye-sensitized (DSC) and/or perovskite solar cells. The solar cells are connected, preferably in series, within the panel so as to provide the electrical current upon illumination of the panel. Generally, DSCs and perovskite solar cells use dyes molecules or perovskite materials for absorbing sunlight and generating electrons that are injected into a semiconductor material. The constructions plan of such solar cells is well known. In an exemplary architecture, such cells comprise a conductive glass or plastics plate, on which the semiconductor material is deposited. The dyes and perovskite are adsorbed or deposited, respectively, on said semiconductor material. An electrolyte or hole transport material may be provided for providing the electrons from a cathode. Various other device architectures have been conceived and described in the art.

In the present specification, the term "photovoltaic" may be abbreviated by PV.

In a preferred embodiment, said solar cells are dye-sensitized solar cells.

In an embodiment, said dye-sensitized and/or perovskite solar cells 15 are transparent and/or translucid with respect to at least some light of the visible light spectrum.

In an embodiment, said dye-sensitized and/or perovskite solar cells 15 are at least partially transparent. Preferably, said solar cells are transparent so as to let pass through them from 0.5% to 80% of the visible light that impinges upon said solar cells. Said percentage expresses percent of the energy of the visible light that passes through the solar cells. Preferably, said cells let pass through them from 1% to 60%, more preferably from 5% to 50%, even more preferably from 10 to 40% or example from 20 to 35% of the visible light that impinges upon said solar cells.

Thanks to the use of transparent supports, such as glass or transparent plastics, and thanks to the presence of an electrolyte and/or the absence of a material that is impervious to light in the construction of said solar cells, the solar cells are at least partially transparent, and have a particular color defined by the dye that is used in the solar cell. In spite of the dye, the light can preferably pass through the solar cells and can also pass through the spaces between neighboring solar cells. The spaces between individual solar cells preferably let visible light pass due to the transparency of support plates and other layers of the construction panel. For example, as will be described in more detail herein below, the PV module is preferably maintained by two support plates made from transparent glass or transparent plastics. These support plates sandwich the PV module and thus are provided on each of the two main opposing sides of the PV module.

Thanks to the features of transparency and the color of the dye, the panels of the invention are aesthetic elements for the construction of railings, for example. In particular, the dye can be green, red, yellow, orange, blue, or indeed of any desired color, such that the overall panel can be adapted, in terms of color, to a particular construction and/or environment. Furthermore, the panels of the invention provide a user, such as a customer and/or installer with a wide offer of choice for selecting an appropriate color that matches the taste of the user.

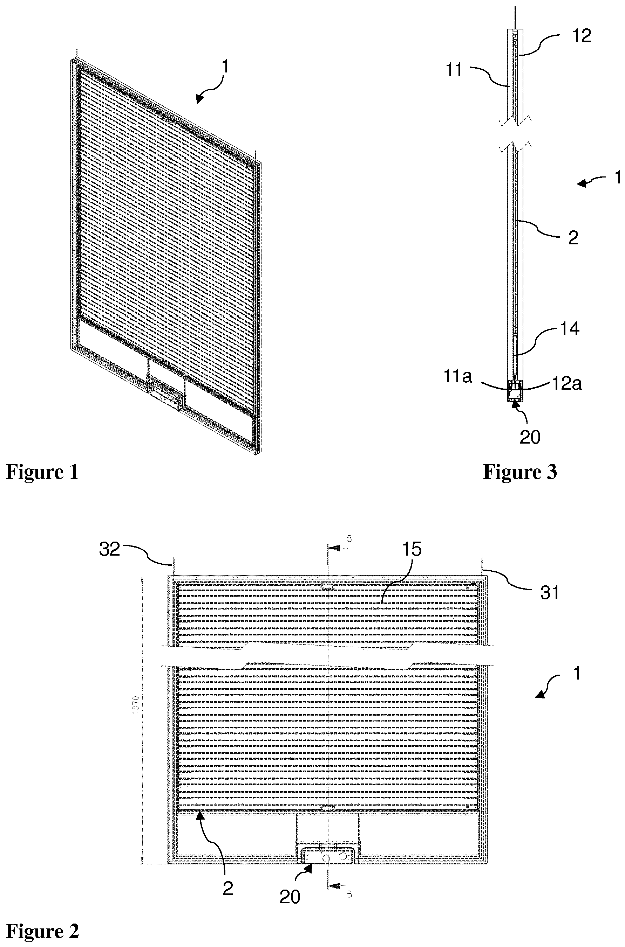

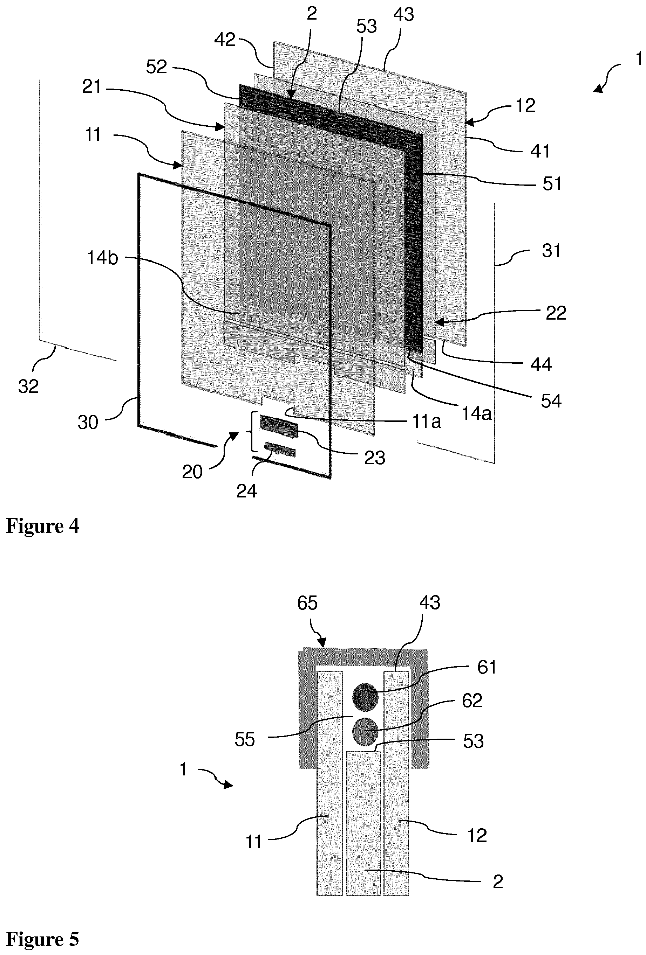

**Figures 1 - 4** show the overall structure of construction panels 1 according to a preferred embodiment. As can in particular be seen in the exploded view of Fig. 4, each panel 1 comprises a PV module 2 comprising said DSCs or perovskite solar cells. Protective plastic foils or laminating films 21, 22 are deposited on each of the two opposed main surfaces of the module 2. The laminating films 21, 22 may be made from thermoplastic polyolefins (TPO), ethylene vinyl acetate (EVA) or polyvinyl butyral (PVB), for example. The photovoltaic module 2 comprising the laminating foil is sandwiched between first and second glass or plastic plates 11, 12, the latter thus providing the colure of the construction panel on the two main (first and second or rear and front) opposing sides of the panel 1.

The plates preferably have the thickness as necessary to provide the required strength and resistance, for example so as to allow the overall panel to be in compliance with legal requirements. In an embodiment, each plate 11, 12 has a thickness of about 6 to 14 mm, preferably from 8 to 12 mm, for example 9-11 mm.

Preferably, the photovoltaic module 2 and the first and second plates 11, 12 have overall square and/or rectangular shapes. Preferably, the module 2 is smaller, that is has shorter lateral sides than the plates 11 and 12, thus that the first and second main opposing flat sides of the module 2 are preferably entirely covered by said plates. Preferably, said plates extend laterally and on the top and bottom beyond said module 2. It is noted, in this regard, that the bottom is preferably the side that is shown on the bottom in Figs 1-4, and the top of the panel is preferably shown on the top side in these figures.

In an embodiment of the construction panel 1, each of said two plates 11, 12 comprises a recess and/or cutout 11a, 12a. In the assembled panel, the recesses are preferably aligned and/or congruent. Therefore, in the assembled panel, said recesses 11a, 12a form a continuous recess. Preferably, a power optimizing element 20 is arranged in said continuous recess 11a, 11b. The optimizing element 20 preferably comprises the power optimizing and electronical control card 24 and a casing 23 in which said control card is housed, for example a plastic box, for protecting and encasing the electronics that are controlling the operation of the panel, as described elsewhere in this specification.

In an embodiment of the construction panel 1, each of said two plates 11, 12 comprises a recess 11a, 12a, wherein, with said panel 1 being assembled, said recesses 11a, 12a form a continuous recess, and wherein said power optimizing element 20 is arranged in said continuous recess 11a, 11b.

It is also noted that the photovoltaic module 2 is somewhat smaller or shorter compared to said plates 11, 12, such that the module does not extend into said continuous recess. The panel comprises two placeholder plates 14a, 14b, which are spaced apart so as to provide a recess, wherein said placeholder plates have preferably substantially the same thickness as said module 2. The placeholder plates 14a, 14b are provided between said plates at the location where the module 2 does not extend, so as to fill the main empty space on the bottom of the panel. The placeholder plates 14a, 14b thus assure that the overall assembled panel has the overall same thickness, and prevents areas on the panel of increased flexibility, where breakage could occur. At the same time, said placeholders 14a, 14b are preferably spaced apart with respect to each other, so as to leave an empty space between them, in which cables and said power optimizer 20 are provided.

In a preferred embodiment, the power optimizing element 20 is integrated directly in the photovoltaic panel 1 and is thus part of it. Preferably, the power optimizing element 20 is permanently integrated and/or sealed in the photovoltaic panel 1. The power optimizing element 20 will be described in more detail below. Preferably, the element 20 is placed in said recess provided by said plates 11, 12, and also between said placeholder plates 14a, 14b.

An edge sealant 30 is preferably provided to laterally surround and thus laterally enclose the photovoltaic module 2. At the bottom of the panel, where the recesses 11a, 12a are provided, a sealant is provided so as to embed and to harbour the power optimizer 20. The sealant 30 is also covered by the two plates 11, 12.

Cable ducts 31, 32 are preferably guided from the power optimizer and control card 24 towards the left and right sides and from there to the top side of panel. The electrical power cables are guided in these cable ducts towards the top.

It has been mentioned that the photovoltaic module 2 has preferably smaller dimensions extending in the plane of the panel compared to the plates 11 and 12. Since the module and the plates 11, 12 are preferably rectangular, the module has preferably shorter sides compared to the sides of the plates 11 and 12.

More specifically, the photovoltaic module 2 preferably has first and second lateral sides 51 and 52, and top and bottom sides 53 and 54, whereas the plates 11, 12 preferably each have first and second lateral sides 41, 42 and top and bottom sides 43 and 44, respectively. Preferably, the first and second plates 11 and 12 have substantially identical external contours and dimensions, such as side lengths.

Preferably, the top and bottom sides 53 and 54 of the photovoltaic module 2 are shorter compared to the top and bottom sides 43 and 44 of the plates 11, 12. Preferably, as already indicated, the lateral sides 51 and 52 of the photovoltaic module are shorter compared to the lateral sides 41, 42 of the plates 11, 12. In this configuration, there remains empty space or channels between the plates 11, 12, once the module 2 is positioned in the appropriate manner between the plates, wherein this space is provided between the plates and along the sides of the module 2, in particular along the lateral sides (or at least one lateral side) and possibly also on the top side of the module 2.

In some of the space between the plates 11, 12 that is not occupied by the module 2, cables and/or ducts for containing and guiding the cables are provided.

The extract of a longitudinal cross section showing the top edge of the construction panel 1 in **Figure 5** shows the groove 55 provided in the top edge of the panel 1, created by the shorter lateral sides of the module 2, enabling an alignment of the module 2 with the plates 11, 12 in such a manner that said groove 55 is created, which extends along the upper edge or side of the overall panel and which is preferably used as a duct for electrical cables 61, 62 that provide the current created by the photovoltaic module 2. In Fig. 5, the cables 61 and 62, extending along the top side 53 of module 2 but between the plates 11, 12 are seen in cross section.

A groove 55 as shown in Fig. 5 may also be provided on one or both lateral sides of the panel 1, by adjusting or selecting the lengths of the top and bottom sides 43, 44, 53, 54 of the plates 11, 12 and of the module 2, respectively, so as to enable positioning of the module between the plates in such a manner so as to provide said lateral grooves.

It is noted that in the final device, the lateral or top and/or bottom grooves containing cable may be closed with a sealant, such as silicone, for example.

In Fig. 5, a cover profile 65 is shown, which covers the groove 55 containing electric wiring. The profile 65 may be a handrail. The handrail 65 may be selected by the installer that uses the panels 1 for providing a railing, for example, together with the profiling that will be used to support and/or anchor the bottom of the panel 1. In some embodiments, the panel 1 resembles a simple glass plate or any other rectangular construction plate in that it has a rectangular overall dimension lacking any salient borders, edges, rivets, nuts, screws or construction elements.

Therefore, the panel 1 is suitable for being used like any conventional glass, plastic or other construction panel and can be readily integrated it into any support structure, such as a frame, footing or railing frame, as commercially available, at the choice of the installer and/or the client. Accordingly, the footing and/or hand rail 65 may be provided together with the panel 1. In some embodiment, the hand rail is not part of the panel 1 of the invention. In another embodiment, the footing is not part of the panel, and in yet an embodiment, neither a handrail nor a footing is part of the panel 1. The latter feature allows the panel 1 to be used as a construction element in manifold construction applications, such as railings, delimitation walls, windows, and the like.

In an embodiment, the panel 1 of the invention lacks a profile suitable for one or more selected from mounting said panel 1, stabilizing said photovoltaic panel 1 and providing a hand-railing to said photovoltaic panel 1, thereby allowing said photovoltaic panel 1 to be used with any suitable profile to be determined at the choice, for example, of a technician, installer and/or end user or client.

In an embodiment, the construction panel 1 has standard dimensions that facilitate and/or render it appropriate for the use in a railing, for example. In an embodiment, the construction panel has lateral dimensions of 90-110 cm (height, length of sides 41, 42) times 70 to 90 cm (width, length of sides 43, 44). In a particular embodiment, the lateral dimensions of the panel are 107 cm x 78 cm. In an embodiment, the panel has a thickness of about 20-40 mm, preferably 24-36 mm.

In a preferred embodiment, the panel of the invention comprises a power optimizing element 20 and/or more generally control circuits 24 for operating the photovoltaic module 2 panel.

Preferably, the power optimizer 20 is adapted for dye-sensitized and/or perovskite solar cells. Preferably, the power optimizer 20 is adapted to protect the photovoltaic module from damaging, for example due to partial or total shadowing of the panel and also in case of different types of shadowing of the panel.

In an embodiment, said power optimizing element 20 is configured to adjust the current of said panel to an amount that prevents occurrence of reverse current and overcurrent in one or several of said plurality of dye-sensitized and/or perovskite solar cells 15 within said photovoltaic module 2.

In an embodiment, said power optimizing element 20 is configured to reduce the current to a safe level in case of partial shadowing of said photovoltaic module 2 and/or in case of shadowing of one or a group of some but not all cells out of said plurality of dye-sensitized and/or perovskite solar cells 15. The term "safe level" refers to a current that is below any current that may cause damage to solar cells of the module 2, such as the overcurrent or reverse current in one or a group of several solar cells of the module 2. The current may be reduced, for example, by adjusting voltage by varying electrical load. Preferably, the power optimizer comprises variable resistances and an algorithm enabling the adjustment of the resistance to an appropriate level.

In an embodiment, said power optimizing element 20 is configured to adjust voltage to the maximum and to scan the electrical load on the module by reducing voltage. In an embodiment, the process is stopped at the first turning point that is detected.

In an embodiment, the current is adjusted such the module operates at or in vicinity to the first turning point and/or the turning point at the highest voltage.

In an embodiment, said power optimizing element 20 is configured to detect the occurrence of a plurality of turning points and/or maximum power points MPPs 80, 81, 82 in the current-voltage curve of said photovoltaic module 2 and to adjust the current output of the entire module 2 to the current of turning point 82 associated with the lowest current and/or with the highest voltage.

The MPPs and/or turning points may be established in various ways, for example in accordance with the following embodiment:
In an embodiment, said power optimizing element 20 is configured to:
- establish the current (I) produced by the panel (1) as a function of voltage (V),
- to determine to occurrence of turning points in said function by using the first derivative with respect to dI/dU, and/or the second derivative d²I/dU², and,
- to adjust the current (I) to an amount that does not exceed the amount of the current associated with the turning point of/at the lowest current (I).

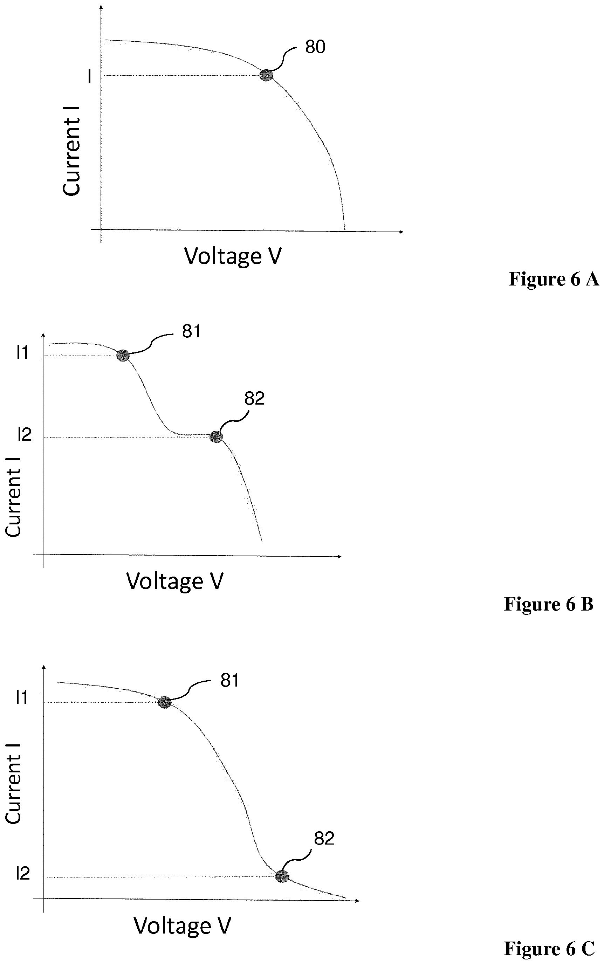

**Figures 6A, 6B** and **6C** illustrate the operation of the power optimizer 20 in accordance with an embodiment of the invention, wherein Fig. 6A represents the classical way of determining a maximum power point (MPP) 80, and operating the photovoltaic module 2 at this MPP so as to optimize the electrical power generated by the module. For example, the voltage may be adjusted so as to have a current that results in operation of the PV module at said MPP.

In case of partial shadowing of the photovoltaic module, the current voltage curves as shown in Fig. 6B and 6C may occur, depending on the solar cells that are shadowed are a continuous stretch of solar cells connected in series in the panel, or if several separate solar cells or groups of solar cells are shadowed. In typical silicone solar cell-based modules, the solar cells of groups thereof may be more or less protected from deleterious currents by security diodes.

In an embodiment, the panel of the invention lacks any blocking and/or security diode destined at protecting solar cells of the modules from damage due to reverse current and/or overcurrent. Security diodes are generally used in silicon based solar cell panels. Typically, one diode is provided for a certain number (a group) of silicon solar cells, for example for 10-30 solar cells, in particular 20 solar cells of a panel comprising several groups, for example containing 60 silicon solar cells, and thus 3 security diodes or more. In silicon based solar cell panels, the security diodes are provided for preventing deleterious currents in case of partial shadowing of the panel.

In accordance with the present invention, the power optimizer 20 establishes the voltage (V) produced by the panel 1 as a function of current (I), for example scanning the current by varying voltage.

By determining the derivative dI/dU, and preferably also the second derivative d²I/dU², at the various positions of the current-voltage function, it is possible to identify turning points in said function. A turning point may be defined, for example as the position on the curve where the sign of the slope of the curve changes from positive to negative, vice versa, or from <1 to >1, from >1 to <1, and the like.

Fig. 6B shows a current-voltage curve having two maximum power points (MPPs) 81, 82, which are defined as the points where the derivative dI/dU turns from smaller than -1 to larger than -1, for example the positions in the curve where the slope is precisely -1.

Further criteria preferably apply, so as to make sure the correct turning points are determined. For example, in Fig. 6B the turning point between the two MPPs may be ignored, for example by taking into account whether the slope turns from steeper to less steep with increasing voltage at a turning point (in this case, the turning point may be ignored in some embodiments), or whether the slope turns from less steep to steeper at a turning point with increasing voltage, in which case the turning point may qualify as an MPP.

In order to prevent any deleterious current within any individual cell or within a group of cells within the plurality of cells of the panel 2, the power optimizer is preferably configured to adjust the current (I) to an amount that does not exceed to the amount of the current associated with the turning point of the lowest current (I). In case of shadowing as illustrated in Fig. 6B, for example, the power optimizer 20 preferably adjusts the operation of the photovoltaic module 2 to a value of (I) corresponding to turning point 82, for example, using the adjustable load and adjusting the current to the value 12.

Fig. 6C shows another current-voltage curve as may be the result of partial shadowing of the photovoltaic module 2. In this case, the curve contains a second turning point at 82, which case reflects a change of the slope from more negative than -1 to less negative than -1 with increasing voltage (or decreasing current). In this case, the turning point is not followed by a further turning point as in Fig. 6B, but the curve flattens out by having a flat, more or less constant slope for the remainder of the curve beyond point 82. Fig. 6C represents a problematic situation that is typical for photovoltaic modules based on dye-sensitized and/or perovskite solar cells, but is generally not found in this form in silicon-based solar cells. The present invention solves problems of damages to solar cells under an illumination and/or shadowing pattern resulting in IV curves as illustrated in Fig. 6C. Preferably, the power optimizer 20 is configured to detect graphs and/or point 82 such as in Fig. 6C and/or to adjust current such that the module operates at the point 82.

The turning point 82 in Fig. 6C being also characteristic for partial shadowing and the risk of currents that are deleterious to at least some of the solar cells, the power optimizer is preferably configured to determine the situation as shown in Fig. 6C and, as in the case of Fig. 6B, to adjust the current to the value 12, which corresponds in this case to the turning point associated with the lowest value for I.

In an embodiment, the algorithm and/or control circuit of the power optimizer 20 are configured to determine current as a function of voltage by scanning the function from high to lower voltage (from the right side to the left side in the graphs of Figs 6A-6C). Preferably, as soon as a turning point such as the points 82 in Figs 6B and 6C is detected, the scanning process is stopped and the photovoltaic module is operated at that turning point. The turning points 82 are the turning points characterized by the lowest current.

The algorithm and/or control circuit of the power optimizer 20 is thus preferably adapted to protect the solar cells in the photovoltaic module 2 from currents that may cause damage the solar cells. The power optimizer is in particular adapted for use with modules comprising dye-sensitized and/or perovskite solar cells.

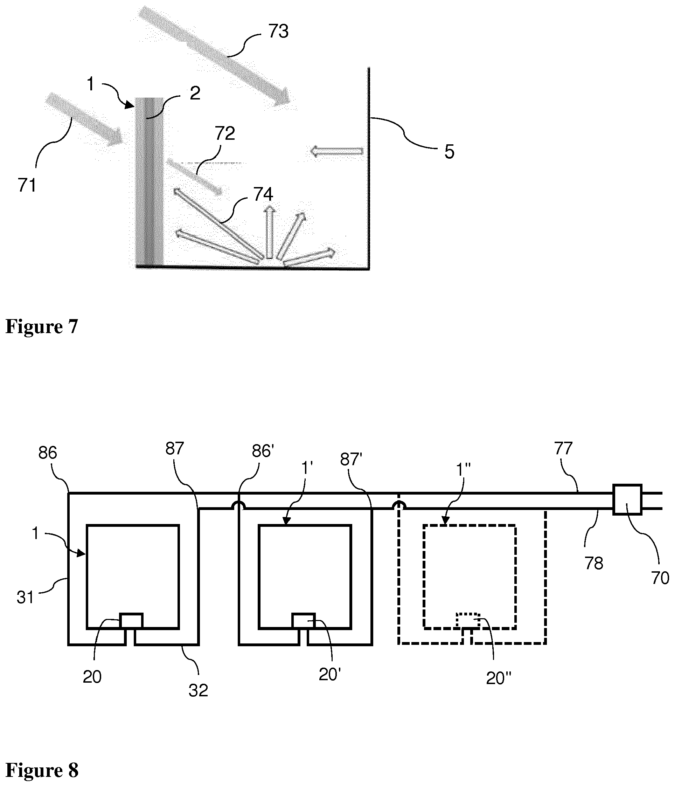

**Figure 7** illustrates the preferred bifacial properties of the construction panel 1. In an embodiment, the panel 1 of the invention is configured to produce electricity when being illuminated on either one of the two opposing sides of the photovoltaic module 2 and/or the photovoltaic panel 1.

The module 2 owes its bifacial properties to the fact that the dye-sensitized and possible perovskite solar cells are transparent to at least some light, which is partially due to the fact that the materials used to prepare the solar cells are at least partially transparent, as set out in more detail elsewhere in this specification. This contrasts the panel of the present invention with photovoltaic panels comprising solar cells based on crystalline silicon, because the latter crystalline silicon is not transparent and is thus impervious to light.

In Fig. 7, the construction panel 1 comprising the photovoltaic module 2 is schematically shown to be used as a railing of a balcony 5. Light 71 may directly impinge upon the panel 1 on a front or first side of the latter and allow the panel to generate electricity. Some light 72 passes through the panel 1, and some light 73 impinges on the wall or the floor of the balcony, where the light is reflected. The reflected light 74 may now again impinge on the construction panel 1, this time from the back or second side. Thanks to the absence of any non-transparent coating on the solar cells, the reflected light 74 may also be used by the panel 1 to generate electricity. In is noted that the bifacial properties described herein are preferably achieved in the absence of a tandem solar cell panel, where there are actually two solar cells or two solar panels placed one on the other, so as to be able to absorb light from both sides. In a preferred embodiment, the photovoltaic module 2 is not a tandem photovoltaic module and/or the construction panel 1 lacks a tandem photovoltaic module.

In an embodiment, the construction panel 1 is configured to be connected in parallel with one or more further construction panels 1', 1" in accordance with the invention.

In an embodiment, the construction panel 1 is configured to be connected, in parallel with one or more additional panels 1', 1", to a single microinverter 70, so as to produce alternate current AC from the direct current (DC) produced from one or more photovoltaic panels 1', 1" connected in parallel.

**Figure 8** illustrates the connection of a plurality or group of constructions panels 1, 1', 1" in parallel and the connection of said plurality of panels to the microinverter 70. The microinverter 70 preferably comprises a DC/AC converts the DC power to AC power adapted to be fed into the grid. The microinverter 70 is thus preferably comprises an appropriate grid connection.

In Figure 8, one of the construction panels (reference numeral 1") is shown in dotted lines, for illustrating that a plurality of two or more, for example 2-10 or 1-5 panels may be connected in parallel. A microinverter 70 is preferably provided for each group of up to about 1-30 panels, preferably 1-20 panels, most preferably 1-10 panels, for example. Furthermore, in Figure 8, the second and further additional panels 1', 1" etc have the same reference numerals as in the previous figures, supplemented with one or more prime signs (') in order to distinguish between panels.

As can also be seen in Fig. 8, in accordance with an embodiment, the construction panels 1, 1', 1", etc panel each comprises a connector module 86, 87; 86', 87', for enabling the connection of the photovoltaic modules 2 of a panel in parallel with a further photovoltaic module of a further panel 1' and/or with a microinverter 70. The connector module 86, 87 may be in the form of one or more connectors, such as female, parts of connectors, for connecting the photovoltaic modules in the panels to the wiring 77, 78 that connects the panels 1, 1", 1" to the microinverter 70, for example.

Instead of converting the current provided by the photovoltaic modules to alternate current, the panels may be connected to a battery charger and/or energy management system, for charging a battery. The battery may then be used to provide electricity to dedicated devices, for example of a household.

In a preferred embodiment, the panel of the invention produces an overall output voltage of 40 volt or less, preferably 37 volt or less, more preferably 36 volt or less, and most preferably 35 volt or less. In a preferred embodiment, the output voltage of the panel is 30 V or less. The output voltage is preferably adjusted by the power optimizer 20, 20', 20" to the appropriate voltage as indicated, such as 30 V or less.

In an embodiment, the nominal power of a construction panel 1 in accordance with the invention is 50 W or lower, preferably 40 W or lower, more preferably 30 W or lower, most preferably 20 W or lower. In an embodiment, the nominal power per panel 1 is in the range of 15-20 W.

In a preferred embodiment, the power output of a group or plurality of panels 1 ,1', 1" conected in parallel is 600 W or lower, preferably 300 W or lower, most preferably 100 W or lower.

Thanks to the electrical characteristics of the construction panels, in terms of voltage output and nominal power, the installation of the construction panel of the invention can be generally made easily, without the need of an IEC certification.

In particular, the construction panels and/or installations comprising two or more such panels preferably qualify as Class III photovoltaic products (norms IEC 61140 and IEC 61730-1:2016).
1 construction panel
2 photovoltaic module
5 balcony wall and floor
11 glass plate
12 glass plate
11a recess in glass plate 11
12a recess in glass plate 12
14 placeholder plate
15 solar cells
20 power optimizing element
21 plastic and/or polymer foil
22 plastic and/or polymer foil
23 casing of power optimizer
24 electronics
30 edge sealant
31, 32 cable ducts
41, 42 lateral sides of plates
43, 44 top and bottom sides of plates
51, 52 lateral sides of photovoltaic module
53, 54 top and bottom sides of panel.
55 space on top edge of panel
61, 62 cables in top
65 handrail
70 microinverter
71 light impinging from front or first side,
72 transmitted light
73 direct light impinging on balcony
74 reflected light
75, 76 connectors for connecting panels to wiring
75', 76' connectors for connecting panels to wiring
77, 78 cable for connecting panels to microconverter

80 MPP / turning point
81 MPP 1 / turning point
82 turning point

86, 87 connectors
86', 87' connectors

## Claims

1. A construction panel (1) for a railing and/or delimitation wall, the panel (1) comprising two plates (11, 12) made of glass or transparent plastics, and, arranged between said two plates (11, 12), a photovoltaic module (2) comprising a plurality of dye-sensitized and/or perovskite solar cells (15), wherein a power optimizing element (20) for controlling the current output of said module (2) is integrated in said construction panel (1).

2. The construction panel (1) of claim 1, wherein said power optimizing element (20) is configured to adjust the current of said panel to an amount that prevents occurrence of reverse current and overcurrent in one or several of said plurality of dye-sensitized and/or perovskite solar cells (15) within said photovoltaic module (2).

3. The construction panel (1) of claim 1 or 2, wherein said power optimizing element (20) is configured to reduce the current to a safe level in case of partial shadowing of said photovoltaic module (2) and/or in case of shadowing of one or a group of some but not all cells out of said plurality of dye-sensitized and/or perovskite solar cells (15).

4. The photovoltaic (1) of any one of the preceding claims, wherein said power optimizing element (20) is configured to detect the occurrence of a plurality of maximum power points (MPPs) and/or turning points in the current-voltage curve of said photovoltaic module (2) and to adjust the current output of the entire module (2) to the current of the turning point associated with the lowest current.

5. The construction panel (1) of any one of the preceding claims, wherein said power optimizing element (20) is configured to:
- establish the current (I) produced by the panel (1) as a function of voltage (V),
- to determine to occurrence of turning points in said function by using the first derivative with respect to dI/dU, and/or the second derivative d²I/dU², and,
- to adjust the current (I) to an amount that does not exceed to the amount of the current associated with the turning point of the lowest current (I).

6. The construction panel of any one of the preceding claims, which lacks any blocking and/or security diode destined at protecting solar cells of the modules from damage due to reverse current and/or overcurrent.

7. The construction panel (1) of any one of the preceding claims, which is configured to produce electricity when being illuminated on either side of the photovoltaic module (2) and/or the construction panel (1).

8. The construction panel (1) of any one of the preceding claims, wherein said dye-sensitized and/or perovskite solar cells (15) are transparent and/or translucid with respect to at least some light of the visible light spectrum.

9. The construction panel (1) of any one of the preceding claims, wherein said dye-sensitized and/or perovskite solar cells (15) are at least partially transparent.

10. The construction panel (1) of any one of the preceding claims, which produces an overall output voltage of 40 volt or less, preferably 37 volt or less, more preferably 36 volt or less, and most preferably 35 volt or less.

11. The construction panel (1) of any one of the preceding claims, which is configured to be connected in parallel with one or more further construction panels (1, 1', 1") in accordance with any one of the preceding claims.

12. The construction panel (1) of any one of the preceding claims, which is configured to be connected, in parallel with one or more additional panels (1', 1"), to a single microinverter (70), so as to produce alternate current (AC) from the direct current (DC) produced from one or more construction panels (1) connected in parallel.

13. The construction panel (1) of any one of the preceding claims, wherein each of said two plates (11, 12) comprises a recess (11a, 12a), wherein, with said panel (1) being assembled, said recesses (11a, 12a) form a continuous recess, and wherein said power optimizing element (20) is arranged in said continuous recess (11a, 11b).

14. The construction panel (1) of claim 9, further comprising a connector module (75, 76; 75', 76'), for enabling the connection of the photovoltaic module (2) of the panel (1) in parallel with a further photovoltaic module of a further panel (1') and/or with a microinverter.

15. The construction panel (1) of any one of the preceding claims, which lacks a profile suitable for one or more selected from mounting said construction panel (1), stabilizing said construction panel (1) and providing a hand-railing to said construction panel (1), thereby allowing said construction panel (1) to be used with any suitable profile to be determined at the choice, for example, of a technician.

16. A construction panel (1) for a railing and/or delimitation wall, the panel (1) comprising a photovoltaic module (2) comprising a plurality of dye-sensitized and/or perovskite solar cells (15), wherein a power optimizing element (20) for controlling the current output of said module (2) is integrated in said construction panel (1).
